# EUROPEAN PATENT SPECIFICATION

(11) **EP 4 465 451 B1**
(45) Date of publication and mention of the grant of the patent: **05.08.2026**
(21) Application number: 24166132.1
(22) Date of filing: 26.03.2024
(51) Int. Cl.: H01R 12/59

(54) **CONNECTOR, CONNECTOR ASSEMBLY, CONNECTING STRUCTURE, AND CONNECTING METHOD**
VERBINDER, VERBINDERANORDNUNG, VERBINDUNGSSTRUKTUR UND VERBINDUNGSVERFAHREN
CONNECTEUR, ENSEMBLE CONNECTEUR, STRUCTURE DE CONNEXION ET PROCÉDÉ DE CONNEXION

(30) Priority: 18.05.2023 JP 2023082234
(43) Date of publication of application: 20.11.2024
(73) Proprietor: Japan Aviation Electronics Industry, Limited, Tokyo 150-0043 (JP)
(72) Inventor: ASHIBU, Kenta, Tokyo, 150-0043 (JP)
(74) Representative: Qip Patent & Recht Dr. Kuehn & Partner mbB

(56) References cited:
- FR-A1- 3 092 942

## Description

### BACKGROUND OF THE INVENTION

The present invention relates to a connector assembly including a connector and a counter connector, particularly a connector that is mounted on a mounting object such as a garment and is fitted to a counter connector.

In addition, the present invention also relates to a connecting method for connecting a plurality of contacts of a connector to a plurality of counter contacts of a counter connector.

In recent years, attention has been drawn to so-called smart clothes that can acquire user's biological data such as the heart rate and the body temperature only by being worn by the user. Such smart cloths have an electrode disposed at a measurement site, and when a wearable device serving as a measurement device is electrically connected to the electrode, biological data can be transmitted to the wearable device.

The electrode and the wearable device can be interconnected by, for instance, use of a connector connected to a wiring portion drawn from the electrode.

As a connector of this type, for example, JP 2015-135723 A discloses a connector as illustrated in FIG. 19. The connector includes a male snap button 2 attached to first cloth 1 and a female snap button 4 attached to second cloth 3. The first cloth 1 and the second cloth 3 are made from conductive cloth, while the male snap button 2 and the female snap button 4 are formed of a conductive material. When a convex portion 5 of the male snap button 2 is inserted into a concave portion 6 of the female snap button 4 and pressed with two bar-like springs 7 of the female snap button 4, the male snap button 2 and the female snap button 4 are electrically connected to each other, whereby the first cloth 1 and the second cloth 3 are electrically connected to each other via the male snap button 2 and the female snap button 4.

Electrical connection of a wearable device can be made using the snap button connector as above, and when the wearable device is detached or the garment is washed for example, the electrical connection via the snap button connector can be released by separating the male snap button 2 from the female snap button 4.

In the snap button connector of JP 2015-135723 A, however, it is necessary to form a spring structure in the female snap button 4 using the two bar-like springs 7 for electrically connecting the female snap button 4 to the male snap button 2, resulting in the increase in the height of the connector, disadvantageously.

In addition, since the entire male snap button 2 and the entire female snap button 4 each function as a single electrode, connections of a plurality of wires would require attachment of as many snap button connectors as the number of the wires to a garment, which hampers miniaturization of a wearable device.

From FR 3 092 942 A1 an electrical or electronic system is known which comprises a first rigid support with a first electrical or electronic circuit part, and at least a first pair of attachment elements, at least one of said attachment elements of said first pair being electrically connected to said first circuit part. The system comprises a second elastically extensible support with a second circuit part and at least a first pair of attachment elements, at least one of said attachment elements of said first pair being electrically connected to said second circuit part.

### SUMMARY OF THE INVENTION

The present invention has been made in order to solve the conventional problems described above and aims at providing a connector assembly capable of achieving miniaturization while the connector is mounted on a mounting object such as a garment.

The present invention aims at providing a connector assembly as defined in claim 1 and including a connector and a counter connector.

In addition, the present invention also aims at providing a connecting method for connecting a plurality of contacts of a connector to a plurality of counter contacts of a counter connector as defined in claim 8.

The connector is a connector which is configured to be mounted on a mounting object and fitted to a counter connector along a fitting direction and which includes a plurality of contacts to be connected to a plurality of counter contacts retained by a housing of the counter connector, the mounting object having a plurality of wiring portions disposed thereon, and the housing having rigidity and insulating property, the connector comprising:
a sheet member extending in a direction orthogonal to the fitting direction and having flexibility and insulating property;
the plurality of contacts retained by the sheet member at positions distanced from each other in a predetermined direction along a surface of the sheet member; and
a plurality of flexible conductors disposed on the sheet member and configured to electrically connect the plurality of contacts to the plurality of wiring portions of the mounting object,
wherein the sheet member is stretchable at least in the predetermined direction, and
with a portion of the sheet member situated between the plurality of contacts being elastically stretched in the predetermined direction, the connector is fitted to the counter connector, and the plurality of contacts separately make contact with and are electrically connected to the plurality of counter contacts due to a shrinking force generated in the sheet member.

The connector assembly according to the present invention comprises:
the foregoing connector; and
the counter connector to which the connector is fitted.

The connecting structure is a connecting structure for connecting a plurality of contacts of a connector, which connector is configured to be mounted on a mounting object and fitted to a counter connector along a fitting direction, to a plurality of counter contacts retained by a housing of the counter connector, the mounting object having a plurality of wiring portions disposed thereon, and the housing having rigidity and insulating property,
wherein the connector includes a sheet member extending in a direction orthogonal to the fitting direction and having flexibility and insulating property, the plurality of contacts retained by the sheet member at positions distanced from each other in a predetermined direction along a surface of the sheet member, and a plurality of flexible conductors disposed on the sheet member and configured to electrically connect the plurality of contacts to the plurality of wiring portions of the mounting object,
the sheet member is stretchable at least in the predetermined direction, and
with a portion of the sheet member situated between the plurality of contacts being elastically stretched in the predetermined direction, the connector is fitted to the counter connector, and the plurality of contacts separately make contact with and are electrically connected to the plurality of counter contacts due to a shrinking force generated in the sheet member.

The connecting method according to the present invention is a connecting method for connecting a plurality of contacts of a connector, which connector is configured to be mounted on a mounting object and fitted to a counter connector along a fitting direction, to a plurality of counter contacts retained by a housing of the counter connector, the mounting object having a plurality of wiring portions disposed thereon, and the housing having rigidity and insulating property,
wherein the connector includes a sheet member extending in a direction orthogonal to the fitting direction and having flexibility and insulating property, the plurality of contacts retained by the sheet member at positions distanced from each other in a predetermined direction along a surface of the sheet member, and a plurality of flexible conductors disposed on the sheet member and configured to electrically connect the plurality of contacts to the plurality of wiring portions of the mounting object,
the sheet member is stretchable at least in the predetermined direction,
the connecting method comprising:
   fitting the connector to the counter connector with a portion of the sheet member situated between the plurality of contacts being elastically stretched in the predetermined direction; and
   making the plurality of contacts separately contact with the plurality of counter contacts due to a shrinking force generated in the sheet member to electrically connect the plurality of contacts to the plurality of counter contacts.

### BRIEF DESCRIPTION OF THE DRAWINGS

FIG. 1 is a perspective view showing a connector assembly according to Embodiment 1 mounted on a mounting object.
FIG. 2 is a plan view showing the connector assembly according to Embodiment 1.
FIG. 3 is a perspective view showing a connector used in Embodiment 1.
FIG. 4 is a perspective view showing a counter connector used in Embodiment 1.
FIG. 5 is a cross-sectional view showing a counter contact of the counter connector used in Embodiment 1.
FIG. 6 is a plan view showing the connector in Embodiment 1 fitted with the counter connector.
FIG. 7 is a cross-sectional view taken along line A-A in FIG. 2.
FIG. 8 is a perspective view showing a connector assembly according to Embodiment 2.
FIG. 9 is a perspective view showing a connector used in Embodiment 2.
FIG. 10 is a perspective view showing a connector assembly according to Embodiment 3.
FIG. 11 is a perspective view showing a connector used in Embodiment 3.
FIG. 12 is a perspective view showing a connector assembly according to Embodiment 4.
FIG. 13 is a plan view showing the connector assembly according to Embodiment 4.
FIG. 14 is a perspective view showing a connector used in Embodiment 4.
FIG. 15 is a perspective view showing a contact of the connector used in Embodiment 4.
FIG. 16 is a perspective view showing a counter connector used in Embodiment 4.
FIG. 17 is a cross-sectional view taken along line B-B in FIG. 13.
FIG. 18 is a side view showing a modification of the connector assembly according to Embodiment 4.
FIG. 19 is a cross-sectional view showing a conventional connector.

### DETAILED DESCRIPTION OF THE INVENTION

Embodiments of the present invention are described below based on the accompanying drawings.

### Embodiment 1

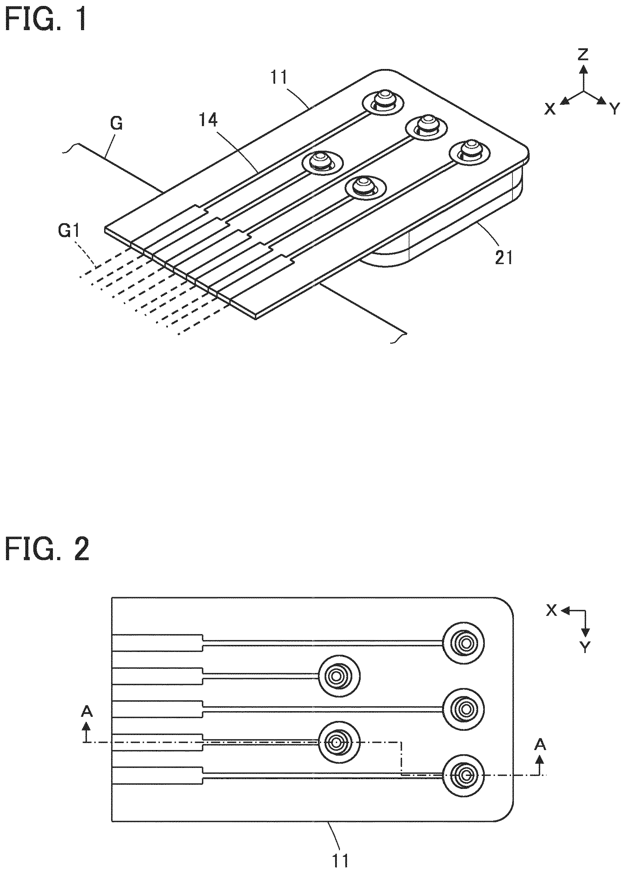

FIGS. 1 and 2 show a connector assembly according to Embodiment 1. The connector assembly includes a connector 11 and a counter connector 21 to which the connector 11 is fitted.

The connector 11 has a sheet shape and is fitted to the counter connector 21 with part of the connector 11 being superposed on the counter connector 21.

For instance, the connector 11 is mounted on a garment G, i.e., a mounting object to be thus used as a garment-side connector, while the counter connector 21 fitted to the connector 11 is used as a module-side connector.

For convenience, the connector 11 having a sheet shape is defined as extending along an XY plane, the direction from the connector 11 to the garment G is referred to as "+X direction," and the direction from the counter connector 21 to the connector 11 and perpendicular to an XY plane is referred to as "+Z direction." The Z direction is a fitting direction of the connector 11 and the counter connector 21.

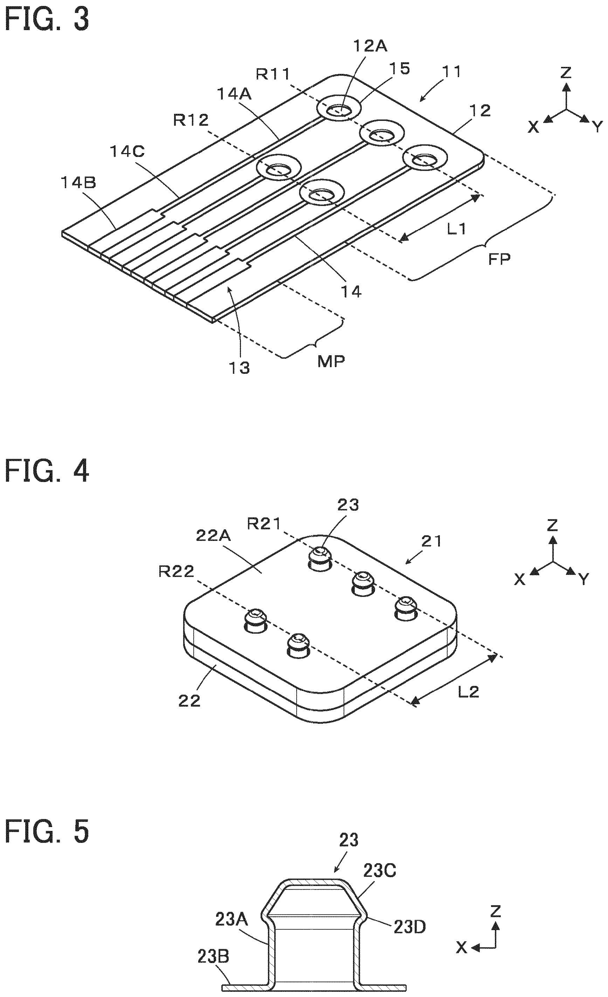

As shown in FIG. 3, the connector 11 includes an insulating sheet member 12 extending along an XY plane. The sheet member 12 includes a fitting portion FP that is arranged at a -X direction side portion of the sheet member 12 and is fitted to the counter connector 21, and a mounting portion MP that is arranged at a +X direction side portion of the sheet member 12 and is mounted on the garment G.

The sheet member 12 is made of, for example, insulating cloth, knitted fabric, or rubber material and is a flexible member that is stretchable at least in the X direction. The sheet member 12 is provided with an embroidery pattern 13 embroidered with embroidery threads.

By using a conductive thread as the embroidery thread to form the embroidery pattern 13, a plurality of flexible conductors 14 having electrical conductivity are formed.

Each flexible conductor 14 includes a linear first connection portion 14A disposed in the fitting portion FP of the sheet member 12 and extending in the X direction, a rectangular second connection portion 14B disposed in the mounting portion MP of the sheet member 12, and a joint portion 14C joining the first connection portion 14A and the second connection portion 14B to each other.

Since the flexible conductors 14 are formed of the embroidery threads, at least the first connection portion 14A extending in the X direction in each flexible conductor 14 is configured to be stretchable in the X direction.

The connector 11 includes a plurality of contacts 15 attached to the fitting portion FP of the sheet member 12 and electrically connected to the first connection portions 14A of the flexible conductors 14.

A contact 15 is a ring-shaped, specifically, a so-called donut-shaped conductive member made of, for example, metal, and is attached to the peripheral portion of a sheet-side through hole 12A formed at a portion of the sheet member 12 at which portion the first connection portion 14A of the corresponding flexible conductor 14 is disposed. As the contact 15, for example, a ring-shaped metal part, so-called "grommet," can be used.

The contacts 15 are separately arranged in a first contact array R11 and a second contact array R12 in a so-called staggered manner, the first contact array R11 extending in the Y direction in a -X direction side portion of the fitting portion FP, and the second contact array R12 extending in the Y direction in a +X direction side portion of the fitting portion FP.

When no external force such as a tensile force acts on the sheet member 12, the center of each contact 15 arranged in the first contact array R11 is distanced from the center of each contact 15 arranged in the second contact array R12 by a distance L1 in the X direction.

As shown in FIG. 4, the counter connector 21 includes an insulating housing 22 having rigidity, and a plurality of counter contacts 23 retained by the housing 22.

The housing 22 includes a connector-opposing surface 22A of planar shape extending along an XY plane and facing in the +Z direction, and the counter contacts 23 have their respective tubular portions protruding in the +Z direction from the connector-opposing surface 22A.

The counter contacts 23 are separately arranged in a first counter contact array R21 and a second counter contact array R22 in a so-called staggered manner, the first counter contact array R21 extending in the Y direction in a -X direction side portion of the housing 22, and the second counter contact array R22 extending in the Y direction in a +X direction side portion of the housing 22.

The center of each counter contact 23 arranged in the first counter contact array R21 is distanced from the center of each counter contact 23 arranged in the second counter contact array R22 by a distance L2 in the X direction.

The distance L2 between the counter contacts 23 in the X direction in the counter connector 21 is set to have a value larger than the distance L1 between the contacts 15 in the X direction in the connector 11 by a difference dL.

The intervals of the centers of the counter contacts 23 in the Y direction in the counter connector 21 are set to be equal to the intervals of the centers of the contacts 15 in the Y direction in the connector 11.

As shown in FIG. 5, each counter contact 23 has a tubular portion 23A of cylindrical shape extending in the +Z direction, and a flange 23B extending from the -Z directional end of the tubular portion 23A along an XY plane. The tubular portion 23A is provided at the +Z directional end thereof with an inviting portion 23C of conical shape tapering toward the +Z direction, and the inviting portion 23C is provided at the - Z directional end thereof with an overhanging portion 23D overhanging in a radial direction relative to the tubular portion 23A. The outer diameter of the overhanging portion 23D is set to be smaller than the inner diameter of the ring-shaped contact 15 in the connector 11, and the tubular portion 23A and the inviting portion 23C are formed such that these portions can be inserted in the ring-shaped contact 15 of the connector 11.

Meanwhile, since the distance L2 in the X direction from the counter contacts 23 arranged in the first counter contact array R21 to the counter contacts 23 arranged in the second counter contact array R22 in the counter connector 21 is longer than the distance L1 in the X direction from the contacts 15 arranged in the first contact array R11 to the contacts 15 arranged in the second contact arrays R12 in the connector 11 by the difference dL, it is not possible to insert all of the counter contacts 23 in the corresponding contacts 15 by merely disposing the fitting portion FP of the connector 11 straight above the counter connector 21.

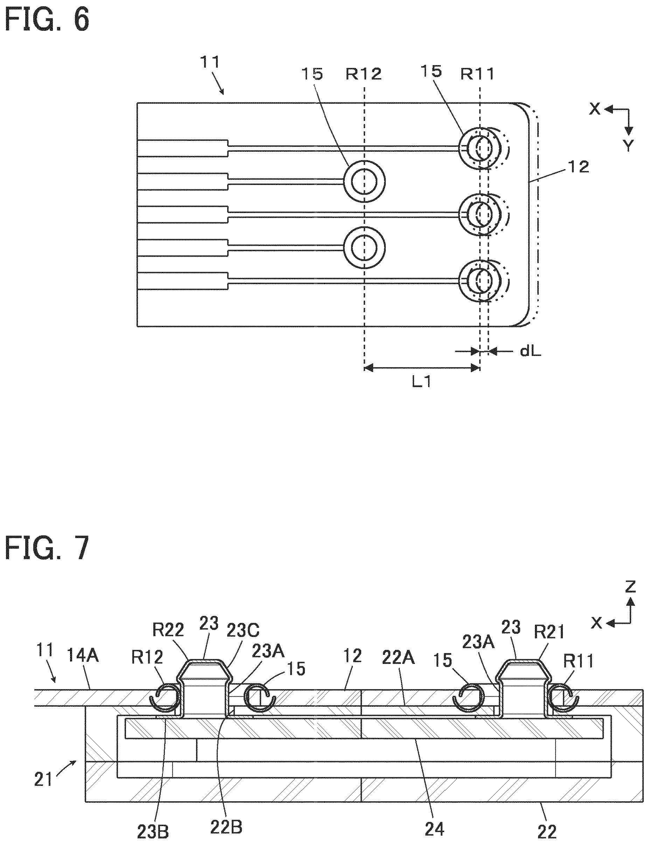

Hence, for fitting the connector 11 to the counter connector 21, first, as indicated by the two-dot chain line in FIG. 6, a tensile force in the X direction is applied to the stretchable sheet member 12 of the connector 11, whereby the distance in the X direction from the centers of the contacts 15 arranged in the first contact array R11 to the centers of the contacts 15 arranged in the second contact array R12 is stretched by the difference dL.

In other words, until the distance in the X direction from the contacts 15 arranged in the first contact array R11 to the contacts 15 arranged in the second contact array R12 of the connector 11 becomes equal to the distance L2 (L1+dL) in the X direction from counter contacts 23 arranged in the first counter contact array R21 to the counter contacts 23 arranged in the second counter contact array R22 of the counter connector 21, a portion of the sheet member 12 situated between the contacts 15 in the connector 11 is stretched in the X direction.

As a result, the positional interrelationship of the contacts 15 of the connector 11 becomes equal to that of the counter contacts 23 of the counter connector 21 both in the X direction and the Y direction.

In this state, the fitting portion FP of the sheet member 12 of the connector 11 is moved toward the connector-opposing surface 22A of the housing 22 of the counter connector 21 in the -Z direction from the +Z direction, whereby the connector 11 is fitted to the counter connector 21, and the counter contacts 23 of the counter connector 21 are separately inserted in the corresponding ring-shaped contacts 15 of the connector 11.

Thereafter, the tensile force in the X direction having been applied to the sheet member 12 of the connector 11 is released, whereby the portion of the sheet member 12 situated between the contacts 15 shrinks in the X direction, and the distance from the centers of the contacts 15 in the first contact array R11 to the centers of the contacts 15 in the second contact array R12 is shortened.

The connector 11 and the counter connector 21 that are fitted to each other in this manner are shown in FIG. 7. A module substrate 24 is included inside the housing 22 of the counter connector 21, and the flanges 23B of the counter contacts 23 are mounted on the module substrate 24. While the tubular portions 23A and the inviting portions 23C of the respective counter contacts 23 protrude in the +Z direction from the connector-opposing surface 22A via through holes 22B of the housing 22 and are inserted in the corresponding ring-shaped contacts 15 of the connector 11, the tensile force having been applied to the sheet member 12 of the connector 11 is released, resulting in generation of a shrinking force in the sheet member 12.

Accordingly, the inner peripheral portions on the -X direction side of the contacts 15 in the first contact array R11 of the connector 11 make contact with the outer peripheral portions on the -X direction side of the counter contacts 23 in the first counter contact array R21 of the counter connector 21 with predetermined contact pressure, and the inner peripheral portions on the +X direction side of the contacts 15 in the second contact array R12 of the connector 11 make contact with the outer peripheral portions on the +X direction side of the counter contacts 23 in the second counter contact array R22 of the counter connector 21 with predetermined contact pressure.

As a result, the contacts 15 of the connector 11 are separately and electrically connected to the counter contacts 23 of the counter connector 21.

As shown in FIG. 1, the bottom surface of the garment G, i.e., a mounting object, is provided with a plurality of conductive wiring portions G1 corresponding to the plurality of flexible conductors 14 of the connector 11, and when the second connection portions 14B disposed in the mounting portion MP of the sheet member 12 of the connector 11 shown in FIG. 3 are each sewn to an end of the corresponding wiring portion G1 of the garment G using, for example, a conductive sewing thread, the flexible conductors 14 are separately and electrically connected to the wiring portions G1 of the garment G.

As a result, the counter contacts 23 of the counter connector 21 can be separately and electrically connected to the wiring portions G1 of the garment G via the contacts 15 and the flexible conductors 14 of the connector 11.

The other ends of the wiring portions G1 each extend along the bottom surface of the garment G up to an electrode (not shown) attached to the garment G.

Hence, when a predetermined electronic circuit is mounted on the module substrate 24 included in the counter connector 21, biological data acquired through the electrode can be measured by the electronic circuit or transmitted to a remote measurement device from the electronic circuit.

In the connector 11 in Embodiment 1, the plurality of flexible conductors 14 and the plurality of ring-shaped contacts 15 are disposed in the flexible and stretchable sheet member 12 that is made of insulating cloth or knitted fabric, the connector 11 is fitted to the counter connector 21 while a portion of the sheet member 12 situated between the contacts 15 is elastically stretched, and the contacts 15 separately make contact with the counter contacts 23 due to a shrinking force generated in the sheet member 12 to be thereby electrically connected to the counter contacts 23; therefore, the connector 11 can achieve miniaturization, particularly reduction in the thickness.

In addition, by mounting the connector 11 to an outside of the garment G, it is possible to suppress deterioration in comfortableness in wearing the garment G even when the connector 11 is fitted to the counter connector 21.

Note that each counter contact 23 has the inviting portion 23C of conical shape tapering toward the +Z direction. Hence, for fitting the connector 11 to the counter connector 21, for instance, in a state where the counter contacts 23 in the second counter contact array R22 of the counter connector 21 are inserted in the through holes of the contacts 15 in the second contact array R12 of the connector 11, the -X directional end of the sheet member 12 is pulled in the -X direction with respect to the counter connector 21, and the contacts 15 in the first contact array R11 are pulled down in the - Z direction when the through holes of the contacts 15 in the first contact array R11 of the connector 11 are superposed on the +Z directional ends, on the +Z direction side, of the inviting portions 23C of the counter contacts 23 in the first counter contact array R21 of the counter connector 21, whereby the counter contacts 23 of the counter connector 21 can be separately inserted in the contacts 15 of the connector 11.

### Embodiment 2

In Embodiment 1 described above, the contacts 15 attached to the sheet member 12 of the connector 11 are each composed of a so-called donut-shaped conductive member, but the invention is not limited thereto.

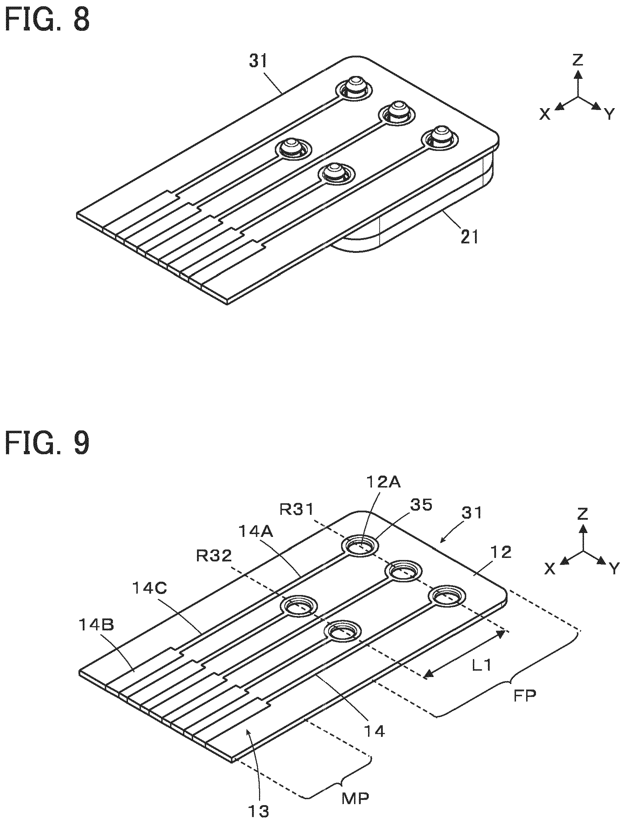

FIG. 8 shows a connector assembly according to Embodiment 2. The connector assembly includes a connector 31 and the counter connector 21 to which the connector 31 is fitted. The counter connector 21 herein is the same as that used in Embodiment 1.

The configuration of the connector 31 is shown in FIG. 9. The connector 31 is configured such that in the connector 11 in Embodiment 1, in place of the contacts 15, a plurality of contacts 35 are attached to the fitting portion FP of the sheet member 12; the connector 31 is otherwise configured similarly to the connector 11. That is, the flexible conductors 14 are formed on the sheet member 12, and the contacts 35 are disposed in the fitting portion FP of the sheet member 12.

The contacts 35 are separately arranged in a first contact array R31 and a second contact array R32, the first contact array R31 extending in the Y direction in a -X direction side portion of the fitting portion FP, and the second contact array R32 extending in the Y direction in a +X direction side portion of the fitting portion FP, and when no external force such as a tensile force acts on the sheet member 12, the center of each contact 35 arranged in the first contact array R31 is distanced from the center of each contact 35 arranged in the second contact array R32 by the distance L1 in the X direction, as with Embodiment 1.

Each contact 35 includes a ring-shaped conductor portion formed along the inner peripheral portion of the sheet-side through hole 12A formed in the sheet member 12, and is electrically connected to the first connection portion 14A of the corresponding flexible conductor 14.

Even with the contacts 35 as above, realized is the connector 31 which is fitted to the counter connector 21 while a portion of the sheet member 12 situated between the contacts 35 is elastically stretched, and in which the contacts 35 separately make contact with and are electrically connected to the counter contacts 23 due to a shrinking force generated in the sheet member 12, similarly to Embodiment 1. As with the connector 11 according to Embodiment 1, the connector 31 can achieve miniaturization, particularly reduction in the thickness.

### Embodiment 3

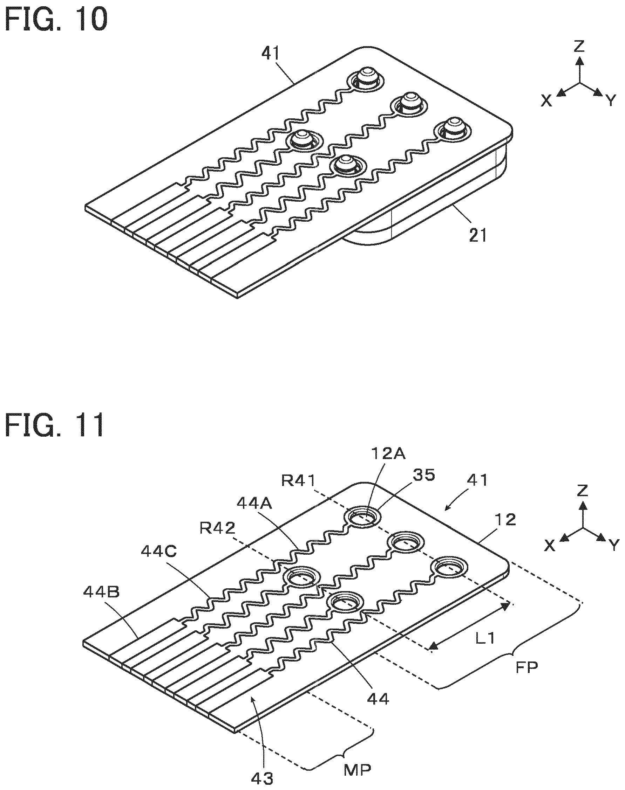

FIG. 10 shows a connector assembly according to Embodiment 3. The connector assembly includes a connector 41 and the counter connector 21 to which the connector 41 is fitted. The counter connector 21 herein is the same as that used in Embodiments 1 and 2.

The configuration of the connector 41 is shown in FIG. 11. The connector 41 is configured such that in the connector 31 in Embodiment 2, in place of the flexible conductors 14, a plurality of flexible conductors 44 are formed on the sheet member 12; the connector 41 is otherwise configured similarly to the connector 31. In other words, the sheet member 12 is provided with an embroidery pattern 43 embroidered with embroidery threads, and the flexible conductors 44 having electrical conductivity are formed of the embroidery pattern 43.

Each flexible conductor 44 includes a first connection portion 44A disposed in the fitting portion FP of the sheet member 12 and extending in the X direction, a rectangular second connection portion 44B disposed in the mounting portion MP of the sheet member 12, and a joint portion 44C joining the first connection portion 44A and the second connection portion 44B to each other. The first connection portion 44A and the joint portion 44C extend in a zigzag manner along the X direction, that is, extend in the X direction while repeatedly bending in the Y direction.

The contacts 35 are separately arranged in a first contact array R41 and a second contact array R42, the first contact array R41 extending in the Y direction in a -X direction side portion of the fitting portion FP, and the second contact array R42 extending in the Y direction in a +X direction side portion of the fitting portion FP, and when no external force such as a tensile force acts on the sheet member 12, the center of each contact 35 arranged in the first contact array R41 is distanced from the center of each contact 35 arranged in the second contact array R42 by the distance L1 in the X direction, as with Embodiments 1 and 2.

Since the first connection portion 44A and the joint portion 44C of each flexible conductor 44 extend in the X direction in a zigzag manner, when the sheet member 12 is stretched in the X direction by a tensile force applied thereto, the first connection portion 44A and the joint portion 44C are deformed in an XY plane such that the bending width in the Y direction of the zigzag shape having repeated bends is narrowed and thus can be elongated in the X direction together with the sheet member 12.

Accordingly, even when the flexible conductors 44 formed of conductive threads do not have sufficient stretchability, it is possible to realize the connector 41 which is fitted to the counter connector 21 while the sheet member 12 is elastically stretched in the X direction, and in which the contacts 35 separately make contact with and are electrically connected to the counter contacts 23 due to a shrinking force generated in the sheet member 12, similarly to Embodiments 1 and 2. Thus, the connector 41 can achieve miniaturization, particularly reduction in the thickness.

### Embodiment 4

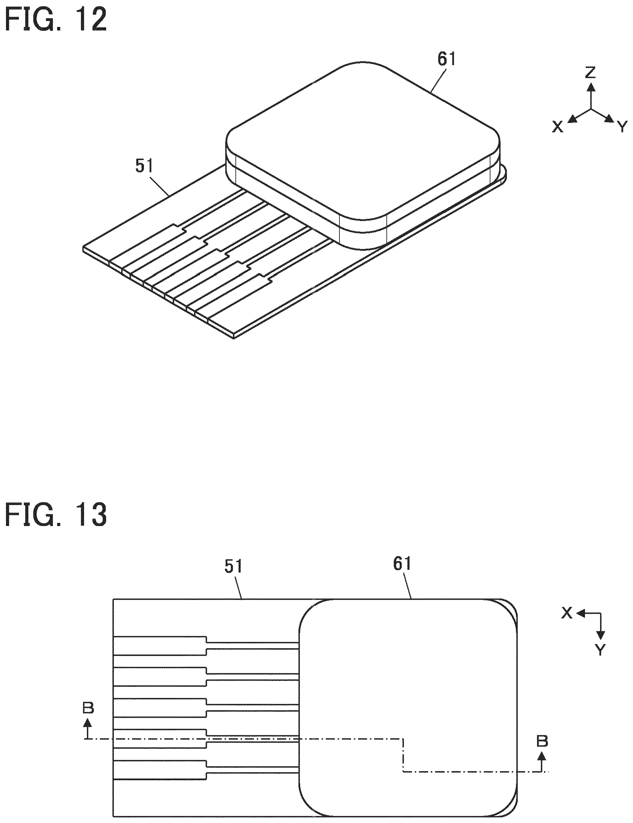

FIGS. 12 and 13 show a connector assembly according to Embodiment 4. The connector assembly includes a connector 51 and a counter connector 61 to which the connector 51 is fitted.

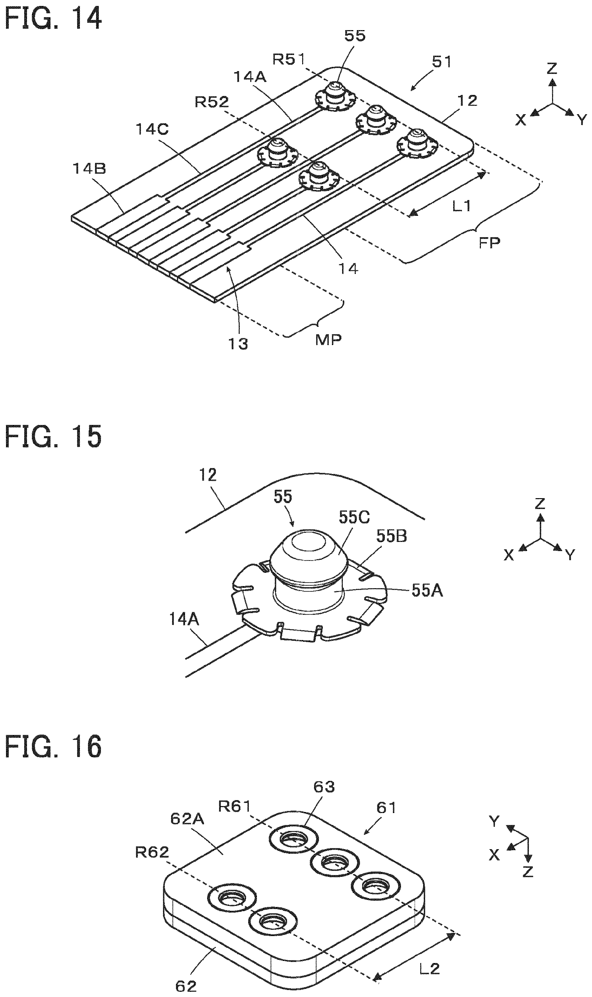

The configuration of the connector 51 is shown in FIG. 14. The connector 51 is configured such that in the connector 11 in Embodiment 1, in place of the contacts 15, a plurality of contacts 55 each projecting in the +Z direction are attached to the fitting portion FP of the sheet member 12; the connector 51 is otherwise configured similarly to the connector 11. That is, the flexible conductors 14 are formed on the sheet member 12, and the contacts 55 are disposed in the fitting portion FP of the sheet member 12.

The contacts 55 are separately arranged in a first contact array R51 and a second contact array R52, the first contact array R51 extending in the Y direction in a -X direction side portion of the fitting portion FP, and the second contact array R52 extending in the Y direction in a +X direction side portion of the fitting portion FP, and when no external force such as a tensile force acts on the sheet member 12, the center of each contact 55 arranged in the first contact array R51 is distanced from the center of each contact 55 arranged in the second contact array R52 by the distance L1 in the X direction, as with Embodiment 1.

As shown in FIG. 15, each contact 55 has a tubular portion 55A of cylindrical shape extending in the +Z direction, and a flange 55B extending from the -Z directional end of the tubular portion 55A along an XY plane. Part of the flange 55B penetrates the sheet member 12 and is bent toward the -Z direction side of the sheet member 12, whereby the contact 55 is retained by the sheet member 12 and is electrically connected to the corresponding first connection portion 14A.

In addition, the tubular portion 55A is provided at the +Z directional end thereof with an inviting portion 55C of conical shape tapering toward the +Z direction.

As shown in FIG. 16, the counter connector 61 includes an insulating housing 62 having rigidity, and a plurality of counter contacts 63 retained by the housing 62.

The housing 62 includes a connector-opposing surface 62A of planar shape extending along an XY plane and facing in the -Z direction, and the counter contacts 63 are retained by the housing 62 so as to be exposed in the -Z direction from the connector-opposing surface 62A.

The counter contacts 63 are separately arranged in a first counter contact array R61 and a second counter contact array R62, the first counter contact array R61 extending in the Y direction in a -X direction side portion of the housing 62, and the second counter contact array R62 extending in the Y direction in a +X direction side portion of the housing 62.

The center of each counter contact 63 arranged in the first counter contact array R61 is distanced from the center of each counter contact 63 arranged in the second counter contact array R62 by a distance L2 in the X direction.

The distance L2 between the counter contacts 63 in the X direction in the counter connector 61 is set to have a value larger than the distance L1 between the contacts 55 in the X direction in the connector 51.

Each counter contact 63 is a flat plate- and ring-shaped conductive member made of, for example, metal and is provided at the center thereof with a through hole in which the tubular portion 55A and the inviting portion 55C of the contact 55 of the connector 51 can be inserted.

For fitting the connector 51 to the counter connector 61, as with Embodiment 1, first, a tensile force in the X direction is applied to the stretchable sheet member 12 of the connector 51, whereby a portion of the sheet member 12 situated between the contacts 55 in the first contact array R51 and the contacts 55 in the second contact array R52 is stretched in the X direction.

In this state, the fitting portion FP of the sheet member 12 of the connector 51 is moved from the -Z direction toward the connector-opposing surface 62A of the housing 62 of the counter connector 61 relatively in the +Z direction, whereby the connector 51 is fitted to the counter connector 61, and the tubular portions 55A and the inviting portions 55C of the contacts 55 of the connector 51 are separately inserted in the corresponding ring-shaped counter contacts 63 of the counter connector 61.

Thereafter, the tensile force in the X direction having been applied to the sheet member 12 of the connector 51 is released, whereby the portion of the sheet member 12 situated between the contacts 55 shrinks in the X direction, and the distance from the centers of the contacts 55 in the first contact array R51 to the centers of the contacts 55 in the second contact array R52 is shortened.

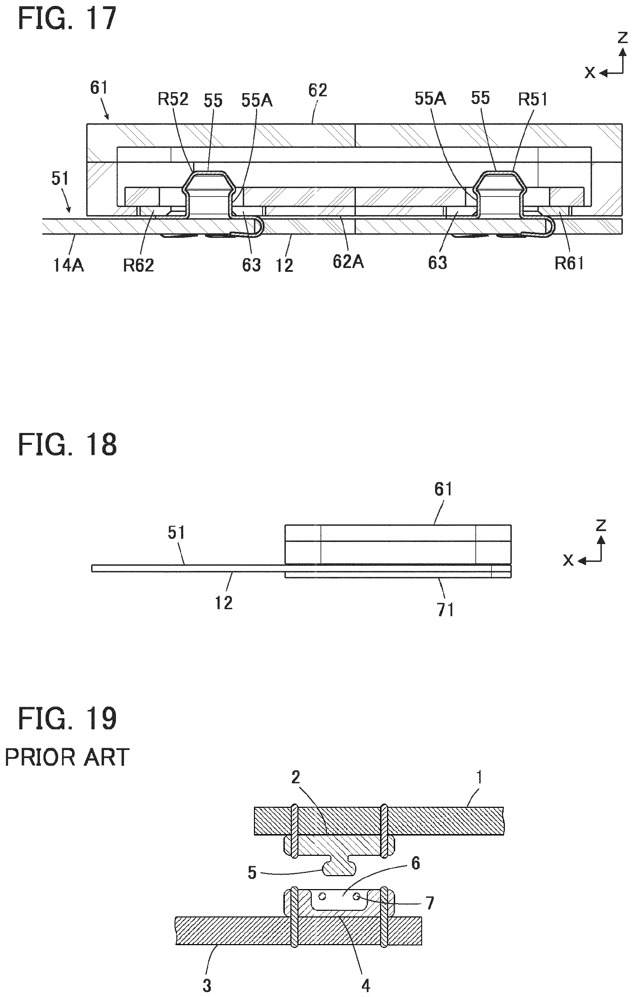

Accordingly, as shown in FIG. 17, the outer peripheral portions on the +X direction side of the contacts 55 in the first contact array R51 of the connector 51 make contact with the inner peripheral portions on the +X direction side of the counter contacts 63 in the first counter contact array R61 of the counter connector 61 with predetermined contact pressure, and the outer peripheral portions on the -X direction side of the contacts 55 in the second contact array R52 of the connector 51 make contact with the inner peripheral portions on the -X direction side of the counter contacts 63 in the second counter contact array R62 of the counter connector 61 with predetermined contact pressure.

As a result, the contacts 55 of the connector 51 are separately and electrically connected to the counter contacts 63 of the counter connector 61.

As described above, even when the contacts 55 projecting in the +Z direction are attached to the flexible and stretchable sheet member 12 of the connector 51, while the ring-shaped counter contacts 63 are disposed in the housing 62 having rigidity of the counter connector 61, it is possible to realize the connector 51 that is miniaturized, particularly thinned.

Meanwhile, as shown in FIG. 18, an auxiliary member 71 can be attached to the opposite surface from the surface facing the counter connector 61, i.e., the -Z directional surface, of the sheet member 12 of the connector 51.

The auxiliary member 71 is made of, for example, a rubber material or a like material and is stretchable at least in the X direction, similarly to the sheet member 12. The auxiliary member 71 is attached at a position corresponding to the fitting portion FP of the sheet member 12.

With the auxiliary member 71 as above being attached to the sheet member 12, even when the sheet member 12 is not sufficiently stretchable, the stretchability of the auxiliary member 71 generates a shrinking force to thereby enable electrical connection between the contacts 55 of the connector 51 and the counter contacts 63 of the counter connector 61 with high reliability.

A similar auxiliary member can be attached to the sheet member 12 not only in the connector 51 of Embodiment 4 but also in the connector 11, 31, 41 of Embodiments 1 to 3. It should be noted that in a case where an auxiliary member is attached to the sheet member 12 in the connector 11, 31, 41 of Embodiments 1 to 3, it is necessary to dispose the auxiliary member on the +Z directional surface of the sheet member 12 and form through holes in the auxiliary member such that tubular portions 23A and the inviting portions 23C of the counter contacts 23 of the counter connector 21 are passed through the through holes.

The number of the contacts 15, 35, 55 of the connector 11, 31, 41, 51 and the number of the counter contacts 22, 63 of the counter connector 21, 61 in Embodiments 1 to 4 described above are not particularly limited, and it suffices if two or more contacts of a connector are configured to be connected to two or more counter contacts of a counter connector.

In addition, while the connector 11, 31, 41, 51 is mounted on the garment G as a mounting object in Embodiments 1 to 4 described above, the mounting object is not limited to the garment G, and the connector can be mounted on various types of mounting objects.

## Claims

1. A connector assembly comprising:
a connector (11, 31, 41, 51); and
a counter connector (21, 61) to which the connector is fitted, wherein the connector (11, 31, 41, 51) is configured to be mounted on a mounting object (G) and fitted to the counter connector (21, 61) along a fitting direction and which includes a plurality of contacts (15, 35, 55) to be connected to a plurality of counter contacts (23, 63) retained by a housing (22, 62) of the counter connector, the mounting object having a plurality of wiring portions (G1) disposed thereon, and the housing having rigidity and insulating property, the connector comprising:
a sheet member (12) extending in a direction orthogonal to the fitting direction and having flexibility and insulating property;
the plurality of contacts (15, 35, 55) retained by the sheet member at positions distanced from each other in a predetermined direction along a surface of the sheet member; and
a plurality of flexible conductors (14, 44) disposed on the sheet member and configured to electrically connect the plurality of contacts to the plurality of wiring portions of the mounting object,
wherein the sheet member (12) is stretchable at least in the predetermined direction, and
with a portion of the sheet member situated between the plurality of contacts being elastically stretched in the predetermined direction, the connector is fitted to the counter connector, and the plurality of contacts separately make contact with and are electrically connected to the plurality of counter contacts due to a shrinking force generated in the sheet member,
**characterised in that**, in a first alternative:
the plurality of counter contacts (23) each include a tubular portion (23A) of cylindrical shape projecting in the fitting direction from the housing and having an inviting portion (23C) of a conical tapering shape at the end thereof,
the plurality of contacts (15, 35) are each formed of a conductive member of ring shape in which a corresponding one of the counter contacts is inserted, and
an inner peripheral portion of the conductive member makes contact with an outer peripheral portion of the tubular portion due to the shrinking force generated in the sheet member;
or **in that**, in a second alternative:
the plurality of contacts (55) each include a tubular portion (55A) of cylindrical shape projecting in the fitting direction from the sheet member and having an inviting portion (55C) of a conical tapering shape at the end thereof,
the plurality of counter contacts (63) are each formed of a conductive member of ring shape in which a corresponding one of the contacts is inserted, and
an outer peripheral portion of the tubular portion makes contact with an inner peripheral portion of the conductive member due to the shrinking force generated in the sheet member.

2. The connector assembly according to claim 1,
wherein the plurality of contacts (15, 35, 55) are separately arranged in two contact arrays (R11, R12, R31, R32, R41, R42, R51, R52), the two contact arrays being distanced from each other in the predetermined direction and each extending in a direction orthogonal to the predetermined direction,
the plurality of counter contacts (23, 63) are separately arranged in two counter contact arrays (R21, R22, R61, R62), the two counter contact arrays being distanced from each other in the predetermined direction and each extending in a direction orthogonal to the predetermined direction, and
when no external force acts on the sheet member, a distance (L2) along the predetermined direction between the two counter contact arrays is longer than a distance (L1) along the predetermined direction between the two contact arrays.

3. The connector assembly according to claim 1 or 2,
wherein the sheet member (12) includes a fitting portion (FP) that is superposed on the counter connector when the connector is fitted to the counter connector, and a mounting portion (MP) that is configured to be mounted on the mounting object,
the plurality of contacts (15, 35, 55) are retained in the fitting portion (FP) of the sheet member, and
the plurality of flexible conductors (14, 44) include a plurality of first connection portions (14A, 44A) disposed in the fitting portion and electrically connected to the plurality of contacts, a plurality of second connection portions (14B, 44B) disposed in the mounting portion and configured to be electrically connected to the plurality of wiring portions of the mounting object, and a plurality of joint portions (14C, 44C) joining the plurality of first connection portions to the plurality of second connection portions.

4. The connector assembly according to any one of claims 1-3,
wherein the sheet member (12) is formed of cloth, knitted fabric, or a rubber material, and
the plurality of flexible conductors (14, 44) are each formed of a conductive thread embroidered on or woven into the sheet member.

5. The connector assembly according to claim 3, wherein the plurality of flexible conductors (44) separately extend from the first connection portions (44A) toward the second connection portions (44B) in a zigzag manner.

6. The connector assembly according to claim 3, further comprising an auxiliary member (71) that is stretchable and is attached to a surface of the sheet member (12) opposite from a surface facing the counter connector and at a position corresponding to the fitting portion.

7. The connector assembly according to any one of claims 1-6, wherein the connector is configured to be mounted on a garment (G) as the mounting object.

8. A connecting method for connecting a connector assembly according to any one of claims 1-7,
the connector assembly comprising: a connector (11, 31, 41, 51); and a counter connector (21, 61) to which the connector is fitted, wherein the connector (11, 31, 41, 51) is configured to be mounted on a mounting object (G) and fitted to the counter connector (21, 61) along a fitting direction and which includes a plurality of contacts (15, 35, 55) to be connected to a plurality of counter contacts (23, 63) retained by a housing (22, 62) of the counter connector, the mounting object having a plurality of wiring portions (G1) disposed thereon, and the housing having rigidity and insulating property, the connector comprising: a sheet member (12) extending in a direction orthogonal to the fitting direction and having flexibility and insulating property; the plurality of contacts (15, 35, 55) retained by the sheet member at positions distanced from each other in a predetermined direction along a surface of the sheet member; and a plurality of flexible conductors (14, 44) disposed on the sheet member and configured to electrically connect the plurality of contacts to the plurality of wiring portions of the mounting object, wherein the sheet member (12) is stretchable at least in the predetermined direction, and with a portion of the sheet member situated between the plurality of contacts being elastically stretched in the predetermined direction, the connector is fitted to the counter connector, and the plurality of contacts separately make contact with and are electrically connected to the plurality of counter contacts due to a shrinking force generated in the sheet member, wherein, in a first alternative: the plurality of counter contacts (23) each include a tubular portion (23A) of cylindrical shape projecting in the fitting direction from the housing and having an inviting portion (23C) of a conical tapering shape at the end thereof, the plurality of contacts (15, 35) are each formed of a conductive member of ring shape in which a corresponding one of the counter contacts is inserted, and an inner peripheral portion of the conductive member makes contact with an outer peripheral portion of the tubular portion due to the shrinking force generated in the sheet member; or wherein, in a second alternative: the plurality of contacts (55) each include a tubular portion (55A) of cylindrical shape projecting in the fitting direction from the sheet member and having an inviting portion (55C) of a conical tapering shape at the end thereof, the plurality of counter contacts (63) are each formed of a conductive member of ring shape in which a corresponding one of the contacts is inserted, and an outer peripheral portion of the tubular portion makes contact with an inner peripheral portion of the conductive member due to the shrinking force generated in the sheet member, the connecting method comprising:
fitting the connector to the counter connector with a portion of the sheet member situated between the plurality of contacts being elastically stretched in the predetermined direction; and
making the plurality of contacts separately contact with the plurality of counter contacts due to a shrinking force generated in the sheet member to electrically connect the plurality of contacts to the plurality of counter contacts.

## Patentansprüche

1. Verbinderanordnung, umfassend:
einen Verbinder (11, 31, 41, 51); und
einen Gegenverbinder (21, 61), an dem der Verbinder angebracht ist, wobei der Verbinder (11, 31, 41, 51) konfiguriert ist, um an einem Montageobjekt (G) montiert zu werden und an dem Gegenverbinder (21, 61) entlang einer Anbringungsrichtung angebracht zu werden, und der eine Vielzahl von Kontakten (15, 35, 55) beinhaltet, die mit einer Vielzahl von Gegenkontakten (23, 63) zu verbinden sind, die durch ein Gehäuse (22, 62) des Gegenverbinders gehalten sind, wobei das Montageobjekt eine Vielzahl von Verdrahtungsabschnitten (G1) aufweist, die daran angeordnet sind, und das Gehäuse eine Steifigkeit und eine Isoliereigenschaft aufweist, wobei der Verbinder umfasst:
ein Plattenelement (12), das sich in einer Richtung orthogonal zu der Anbringungsrichtung erstreckt und eine Flexibilität und eine Isoliereigenschaft aufweist;
die Vielzahl von Kontakten (15, 35, 55), die durch das Plattenelement an Positionen gehalten werden, die voneinander in einer vorbestimmten Richtung entlang einer Oberfläche des Plattenelements beabstandet sind; und
eine Vielzahl von flexiblen Leitern (14, 44), die an dem Plattenelement angeordnet sind und konfiguriert sind, um die Vielzahl von Kontakten mit der Vielzahl von Verdrahtungsabschnitten des Montageobjekts elektrisch zu verbinden,
wobei das Plattenelement (12) zumindest in der vorbestimmten Richtung dehnbar ist, und
wenn ein Abschnitt des Plattenelements, der sich zwischen der Vielzahl von Kontakten befindet, in der vorbestimmten Richtung elastisch gedehnt ist, ist der Verbinder an dem Gegenverbinder angebracht, und die Vielzahl von Kontakten kommen separat mit der Vielzahl von Gegenkontakten in Kontakt und sind elektrisch mit diesen verbunden aufgrund einer Schrumpfkraft, die in dem Plattenelement erzeugt wird, **dadurch gekennzeichnet, dass**, in einer ersten Alternative:
die Vielzahl von Gegenkontakten (23) jeweils einen röhrenförmigen Abschnitt (23A) mit einer zylindrischen Form beinhalten, der in der Anbringungsrichtung von dem Gehäuse vorsteht und einen einladenden Abschnitt (23C) mit einer konisch zulaufenden Form an seinem Ende aufweist,
die Vielzahl von Kontakten (15, 35) jeweils aus einem leitfähigen Element mit einer Ringform gebildet sind, in das ein entsprechender der Gegenkontakte eingesetzt ist, und
ein Innenumfangsabschnitt des leitfähigen Elements aufgrund der Schrumpfkraft, die in dem Plattenelement erzeugt wird, mit einem Außenumfangsabschnitt des röhrenförmigen Abschnitts in Kontakt kommt;
oder dadurch, dass in einer zweiten Alternative:
die Vielzahl von Kontakten (55) jeweils einen röhrenförmigen Abschnitt (55A) mit einer zylindrischen Form beinhalten, der in der Anbringungsrichtung von dem Plattenelement vorsteht und einen einladenden Abschnitt (55C) mit einer konisch zulaufenden Form an seinem Ende aufweist,
die Vielzahl von Gegenkontakten (63) jeweils aus einem leitfähigen Element mit einer Ringform gebildet sind, in das ein entsprechender der Kontakte eingesetzt ist, und
ein Außenumfangsabschnitt des röhrenförmigen Abschnitts aufgrund der Schrumpfkraft, die in dem Plattenelement erzeugt wird, mit einem Innenumfangsabschnitt des leitfähigen Elements in Kontakt kommt.

2. Verbinderanordnung nach Anspruch 1,
wobei die Vielzahl von Kontakten (15, 35, 55) separat in zwei Kontaktanordnungen (R11, R12, R31, R32, R41, R42, R51, R52) angeordnet sind, wobei die zwei Kontaktanordnungen voneinander in der vorbestimmten Richtung beabstandet sind und sich jeweils in einer Richtung orthogonal zu der vorbestimmten Richtung erstrecken,
die Vielzahl von Gegenkontakten (23, 63) separat in zwei Gegenkontaktanordnungen (R21, R22, R61, R62) angeordnet sind, wobei die zwei Gegenkontaktanordnungen voneinander in der vorbestimmten Richtung beabstandet sind und sich jeweils in einer Richtung orthogonal zu der vorbestimmten Richtung erstrecken, und
wenn keine externe Kraft auf das Plattenelement wirkt, ein Abstand (L2) entlang der vorbestimmten Richtung zwischen den zwei Gegenkontaktanordnungen länger als ein Abstand (L1) entlang der vorbestimmten Richtung zwischen den zwei Kontaktanordnungen ist.

3. Verbinderanordnung nach Anspruch 1 oder 2,
wobei das Plattenelement (12) einen Anbringungsabschnitt (FP), der auf dem Gegenverbinder überlagert ist, wenn der Verbinder an dem Gegenverbinder angebracht ist, und einen Montageabschnitt (MP), der konfiguriert ist, um an dem Montageobjekt montiert zu werden, beinhaltet,
die Vielzahl von Kontakten (15, 35, 55) in dem Anbringungsabschnitt (FP) des Plattenelements gehalten sind, und
die Vielzahl von flexiblen Leitern (14, 44) eine Vielzahl von ersten Verbindungsabschnitten (14A, 44A), die in dem Anbringungsabschnitt angeordnet sind und mit der Vielzahl von Kontakten elektrisch verbunden sind, eine Vielzahl von zweiten Verbindungsabschnitten (14B, 44B), die in dem Montageabschnitt angeordnet sind und konfiguriert sind, um mit der Vielzahl von Verdrahtungsabschnitten des Montageobjekts elektrisch verbunden zu werden, und eine Vielzahl von Verbindungsabschnitten (14C, 44C), die die Vielzahl von ersten Verbindungsabschnitten mit der Vielzahl von zweiten Verbindungsabschnitten verbinden, beinhaltet.

4. Verbinderanordnung nach einem der Ansprüche 1-3,
wobei das Plattenelement (12) aus Stoff, Gewirke oder einem Gummimaterial gebildet ist, und
die Vielzahl von flexiblen Leitern (14, 44) jeweils aus einem leitfähigen Faden gebildet sind, der an das Plattenelement gestickt oder in dieses eingewebt ist.

5. Verbinderanordnung nach Anspruch 3, wobei sich die Vielzahl von flexiblen Leitern (44) getrennt von den ersten Verbindungsabschnitten (44A) zu den zweiten Verbindungsabschnitten (44B) in einer Zickzack-Weise erstrecken.

6. Verbinderanordnung nach Anspruch 3, ferner umfassend ein Hilfselement (71), das dehnbar ist und an einer Oberfläche des Plattenelements (12) gegenüber einer Oberfläche, die dem Gegenverbinder zugewandt ist, und an einer Position, die dem Anbringungsabschnitt entspricht, angebracht ist.

7. Verbinderanordnung nach einem der Ansprüche 1-6, wobei der Verbinder konfiguriert ist, um an einem Kleidungsstück (G) als das Montageobjekt montiert zu werden.

8. Verbindungsverfahren zum Verbinden einer Verbinderanordnung nach einem der Ansprüche 1-7,
wobei die Verbinderanordnung umfasst: einen Verbinder (11, 31, 41, 51); und einen Gegenverbinder (21, 61), an dem der Verbinder angebracht ist, wobei der Verbinder (11, 31, 41, 51) konfiguriert ist, um an einem Montageobjekt (G) montiert zu werden und an dem Gegenverbinder (21, 61) entlang einer Anbringungsrichtung angebracht zu werden, und der eine Vielzahl von Kontakten (15, 35, 55) beinhaltet, die mit einer Vielzahl von Gegenkontakten (23, 63) zu verbinden sind, die durch ein Gehäuse (22, 62) des Gegenverbinders gehalten werden, wobei das Montageobjekt eine Vielzahl von Verdrahtungsabschnitten (G1) aufweist, die darauf angeordnet sind, und das Gehäuse eine Steifigkeit und eine Isoliereigenschaft aufweist, wobei der Verbinder umfasst: ein Plattenelement (12), das sich in einer Richtung orthogonal zu der Anbringungsrichtung erstreckt und eine Flexibilität und eine Isoliereigenschaft aufweist; die Vielzahl von Kontakten (15, 35, 55), die durch das Plattenelement an Positionen gehalten werden, die voneinander in einer vorbestimmten Richtung entlang einer Oberfläche des Plattenelements beabstandet sind; und eine Vielzahl von flexiblen Leitern (14, 44), die an dem Plattenelement angeordnet sind und konfiguriert sind, um die Vielzahl von Kontakten mit der Vielzahl von Verdrahtungsabschnitten des Montageobjekts elektrisch zu verbinden, wobei das Plattenelement (12) zumindest in der vorbestimmten Richtung dehnbar ist, und wenn ein Abschnitt des Plattenelements, der sich zwischen der Vielzahl von Kontakten befindet, in der vorbestimmten Richtung elastisch gedehnt ist, ist der Verbinder an dem Gegenverbinder angebracht, und die Vielzahl von Kontakten, kommen separat mit der Vielzahl von Gegenkontakten in Kontakt und sind elektrisch mit diesen verbunden aufgrund einer Schrumpfkraft, die in dem Plattenelement erzeugt wird, wobei in einer ersten Alternative: die Vielzahl von Gegenkontakten (23) jeweils einen röhrenförmigen Abschnitt (23A) mit einer zylindrischen Form beinhalten, der in der Anbringungsrichtung von dem Gehäuse vorsteht und einen einladenden Abschnitt (23C) mit einer konisch zulaufenden Form an seinem Ende aufweist, die Vielzahl von Kontakten (15, 35) jeweils aus einem leitfähigen Element mit einer Ringform gebildet sind, in das ein entsprechender der Gegenkontakte eingesetzt ist, und ein Innenumfangsabschnitt des leitfähigen Elements aufgrund der Schrumpfkraft, die in dem Plattenelement erzeugt wird, mit einem Außenumfangsabschnitt des röhrenförmigen Abschnitts in Kontakt kommt; oder wobei in einer zweiten Alternative: die Vielzahl von Kontakten (55) jeweils einen röhrenförmigen Abschnitt (55A) mit einer zylindrischen Form beinhalten, der in der Anbringungsrichtung von dem Plattenelement vorsteht und einen einladenden Abschnitt (55C) mit einer konisch zulaufenden Form an seinem Ende aufweist, die Vielzahl von Gegenkontakten (63) jeweils aus einem leitfähigen Element mit einer Ringform gebildet sind, in das ein entsprechender der Kontakte eingesetzt ist, und ein Außenumfangsabschnitt des röhrenförmigen Abschnitts aufgrund der Schrumpfkraft, die in dem Plattenelement erzeugt wird, mit einem Innenumfangsabschnitt des leitfähigen Elements in Kontakt kommt,
wobei das Verbindungsverfahren umfasst:
Anbringen des Verbinders an dem Gegenverbinder, wobei ein Abschnitt des Plattenelements, der sich zwischen der Vielzahl von Kontakten befindet, in der vorbestimmten Richtung elastisch gedehnt wird; und
Herstellen eines separaten Kontakts der Vielzahl von Kontakten mit der Vielzahl von Gegenkontakten aufgrund einer Schrumpfkraft, die in dem Plattenelement erzeugt wird, um die Vielzahl von Kontakten mit der Vielzahl von Gegenkontakten elektrisch zu verbinden.

## Revendications

1. Ensemble connecteur comprenant :
un connecteur (11, 31, 41, 51) ; et
un contre-connecteur (21, 61) sur lequel le connecteur est monté, dans lequel le connecteur (11, 31, 41, 51) est configuré pour être monté sur un objet de montage (G) et monté sur le contre-connecteur (21, 61) le long d'une direction de montage et qui comprend une pluralité de contacts (15, 35, 55) à connecter à une pluralité de contre-contacts (23, 63) retenus par un boîtier (22, 62) du contre-connecteur, l'objet de montage ayant une pluralité de parties de câblage (G1) disposées sur celui-ci, et le boîtier ayant une rigidité et une propriété isolante, le connecteur comprenant :
un élément en feuille (12) s'étendant dans une direction orthogonale à la direction de montage et ayant une flexibilité et une propriété isolante ;
la pluralité de contacts (15, 35, 55) retenus par l'élément en feuille à des positions espacées les unes des autres dans une direction prédéterminée le long d'une surface de l'élément en feuille ; et
une pluralité de conducteurs flexibles (14, 44) disposés sur l'élément en feuille et configurés pour connecter électriquement la pluralité de contacts à la pluralité de parties de câblage de l'objet de montage,
dans lequel l'élément en feuille (12) est étirable au moins dans la direction prédéterminée, et
avec une partie de l'élément en feuille située entre la pluralité de contacts étant étirée élastiquement dans la direction prédéterminée, le connecteur est monté sur le contre-connecteur, et la pluralité de contacts établissent séparément un contact avec et sont connectés électriquement à la pluralité de contre-contacts en raison d'une force de rétraction générée dans l'élément en feuille,
**caractérisé en ce que**, dans une première alternative :
la pluralité de contre-contacts (23) comprennent chacun une partie tubulaire (23A) de forme cylindrique faisant saillie dans la direction de montage à partir du boîtier et ayant une partie d'invitation (23C) de forme conique effilée à son extrémité,
la pluralité de contacts (15, 35) sont chacun formés d'un élément conducteur de forme annulaire dans lequel un contre-contact correspondant des contre-contacts est inséré, et
une partie périphérique interne de l'élément conducteur établit un contact avec une partie périphérique externe de la partie tubulaire en raison de la force de rétraction générée dans l'élément en feuille ;
ou **en ce que**, dans une seconde alternative :
la pluralité de contacts (55) comprennent chacun une partie tubulaire (55A) de forme cylindrique faisant saillie dans la direction de montage à partir de l'élément en feuille et ayant une partie d'invitation (55C) de forme conique effilée à son extrémité,
la pluralité de contre-contacts (63) sont chacun formés d'un élément conducteur de forme annulaire dans lequel un contact correspondant des contacts est inséré, et
une partie périphérique externe de la partie tubulaire établit un contact avec une partie périphérique interne de l'élément conducteur en raison de la force de rétraction générée dans l'élément en feuille.

2. Ensemble connecteur selon la revendication 1,
dans lequel la pluralité de contacts (15, 35, 55) sont agencés séparément dans deux réseaux de contacts (R11, R12, R31, R32, R41, R42, R51, R52), les deux réseaux de contacts étant espacés l'un de l'autre dans la direction prédéterminée et s'étendant chacun dans une direction orthogonale à la direction prédéterminée,
la pluralité de contre-contacts (23, 63) sont agencés séparément dans deux réseaux de contre-contacts (R21, R22, R61, R62), les deux réseaux de contre-contacts étant espacés l'un de l'autre dans la direction prédéterminée et s'étendant chacun dans une direction orthogonale à la direction prédéterminée, et
lorsqu'aucune force externe n'agit sur l'élément en feuille, une distance (L2) le long de la direction prédéterminée entre les deux réseaux de contre-contacts est plus longue qu'une distance (L1) le long de la direction prédéterminée entre les deux réseaux de contacts.

3. Ensemble connecteur selon la revendication 1 ou 2,
dans lequel l'élément en feuille (12) comprend une partie de montage (FP) qui est superposée sur le contre-connecteur lorsque le connecteur est monté sur le contre-connecteur, et une partie de montage (MP) qui est configurée pour être montée sur l'objet de montage,
la pluralité de contacts (15, 35, 55) sont retenus dans la partie de montage (FP) de l'élément en feuille, et
la pluralité de conducteurs flexibles (14, 44) comprennent une pluralité de premières parties de connexion (14A, 44A) disposées dans la partie de montage et connectées électriquement à la pluralité de contacts, une pluralité de secondes parties de connexion (14B, 44B) disposées dans la partie de montage et configurées pour être connectées électriquement à la pluralité de parties de câblage de l'objet de montage, et une pluralité de parties de jonction (14C, 44C) joignant la pluralité de premières parties de connexion à la pluralité de secondes parties de connexion.

4. Ensemble connecteur selon l'une quelconque des revendications 1 à 3,
dans lequel l'élément en feuille (12) est formé d'un tissu, d'un tissu tricoté, ou d'un matériau en caoutchouc, et
la pluralité de conducteurs flexibles (14, 44) sont chacun formés d'un fil conducteur brodé sur ou tissé dans l'élément en feuille.

5. Ensemble connecteur selon la revendication 3, dans lequel la pluralité de conducteurs flexibles (44) s'étendent séparément des premières parties de connexion (44A) vers les secondes parties de connexion (44B) d'une manière en zigzag.

6. Ensemble connecteur selon la revendication 3, comprenant en outre un élément auxiliaire (71) qui est étirable et est fixé à une surface de l'élément en feuille (12) opposée à une surface faisant face au contre-connecteur et à une position correspondant à la partie de montage.

7. Ensemble connecteur selon l'une quelconque des revendications 1 à 6, dans lequel le connecteur est configuré pour être monté sur un vêtement (G) en tant qu'objet de montage.

8. Procédé de connexion pour connecter un ensemble connecteur selon l'une quelconque des revendications 1 à 7,
l'ensemble connecteur comprenant : un connecteur (11, 31, 41, 51) ; et un contre-connecteur (21, 61) sur lequel le connecteur est monté, dans lequel le connecteur (11, 31, 41, 51) est configuré pour être monté sur un objet de montage (G) et monté sur le contre-connecteur (21, 61) le long d'une direction de montage et qui comprend une pluralité de contacts (15, 35, 55) à connecter à une pluralité de contre-contacts (23, 63) retenus par un boîtier (22, 62) du contre-connecteur, l'objet de montage ayant une pluralité de parties de câblage (G1) disposées sur celui-ci, et le boîtier ayant une rigidité et une propriété isolante, le connecteur comprenant : un élément en feuille (12) s'étendant dans une direction orthogonale à la direction de montage et ayant une flexibilité et une propriété isolante ; la pluralité de contacts (15, 35, 55) retenus par l'élément en feuille à des positions espacées les unes des autres dans une direction prédéterminée le long d'une surface de l'élément en feuille ; et une pluralité de conducteurs flexibles (14, 44) disposés sur l'élément en feuille et configurés pour connecter électriquement la pluralité de contacts à la pluralité de parties de câblage de l'objet de montage, dans lequel l'élément en feuille (12) est étirable au moins dans la direction prédéterminée, et avec une partie de l'élément en feuille située entre la pluralité de contacts étant étirée élastiquement dans la direction prédéterminée, le connecteur est monté sur le contre-connecteur, et la pluralité de contacts établissent séparément un contact avec et sont connectés électriquement à la pluralité de contre-contacts en raison d'une force de rétraction générée dans l'élément en feuille, dans lequel, dans une première alternative : la pluralité de contre-contacts (23) comprennent chacun une partie tubulaire (23A) de forme cylindrique faisant saillie dans la direction de montage à partir du boîtier et ayant une partie d'invitation (23C) de forme conique effilée à son extrémité, la pluralité de contacts (15, 35) sont chacun formés d'un élément conducteur de forme annulaire dans lequel un contact correspondant des contre-contacts est inséré, et une partie périphérique interne de l'élément conducteur établit un contact avec une partie périphérique externe de la partie tubulaire en raison de la force de rétraction générée dans l'élément en feuille ; ou dans lequel, dans une seconde alternative : la pluralité de contacts (55) comprennent chacun une partie tubulaire (55A) de forme cylindrique faisant saillie dans la direction de montage à partir de l'élément en feuille et ayant une partie d'invitation (55C) de forme conique effilée à son extrémité, la pluralité de contre-contacts (63) sont chacun formés d'un élément conducteur de forme annulaire dans lequel un contact correspondant des contacts est inséré, et une partie périphérique externe de la partie tubulaire établit un contact avec une partie périphérique interne de l'élément conducteur en raison de la force de rétraction générée dans l'élément en feuille,
le procédé de connexion comprenant :
le montage du connecteur sur le contre-connecteur avec une partie de l'élément en feuille située entre la pluralité de contacts étant étirée élastiquement dans la direction prédéterminée ; et
l'établissement de la pluralité de contacts séparément en contact avec la pluralité de contre-contacts en raison d'une force de rétraction générée dans l'élément en feuille pour connecter électriquement la pluralité de contacts à la pluralité de contre-contacts.
